(19) Europäisches Patentamt
European Patent Office
Office européen des brevets

(11) **EP 4 433 869 B1**

(12) **EUROPEAN PATENT SPECIFICATION**

(45) Date of publication and mention of the grant of the patent:
**27.08.2025 Bulletin 2025/35**

(21) Application number: **22809130.2**

(22) Date of filing: **26.10.2022**

(51) International Patent Classification (IPC):
**G03F 1/36** *(2012.01)*  **G03F 1/70** *(2012.01)*
**G03F 7/00** *(2006.01)*

(52) Cooperative Patent Classification (CPC):
**G03F 1/36; G03F 1/70; G03F 7/70441; G03F 7/705; G03F 7/70625**

(86) International application number:
**PCT/EP2022/079894**

(87) International publication number:
**WO 2023/088649 (25.05.2023 Gazette 2023/21)**

(54) **DETERMINING AN ETCH EFFECT BASED ON AN ETCH BIAS DIRECTION**

BESTIMMUNG EINES ÄTZEFFEKTS AUF BASIS EINER GERICHTETEN ÄTZRESERVE

DÉTERMINATION D'UN EFFET DE GRAVURE SUR LA BASE D'UNE DIRECTION DE POLARISATION DE GRAVURE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **17.11.2021 US 202163280468 P**

(43) Date of publication of application:
**25.09.2024 Bulletin 2024/39**

(73) Proprietor: **ASML Netherlands B.V.**
**5500 AH Veldhoven (NL)**

(72) Inventors:
• **CHENG, Jin**
  **San Jose, California 95134-1720 (US)**
• **CHEN, Feng**
  **San Jose, California 95134-1720 (US)**
• **ZHENG, Leiwu**
  **San Jose, California 95134-1720 (US)**
• **FAN, Yongfa**
  **San Jose, California 95134-1720 (US)**
• **LU, Yen-Wen**
  **San Jose, California 95134-1720 (US)**
• **WANG, Jen-Shiang**
  **San Jose, California 95134-1720 (US)**
• **MA, Ziyang**
  **San Jose, California 95134-1720 (US)**
• **ZHU, Dianwen**
  **San Jose, California 95134-1720 (US)**
• **CHEN, Xi**
  **San Jose, California 95134-1720 (US)**
• **ZHAO, Yu**
  **San Jose, California 95134-1720 (US)**

(74) Representative: **ASML Netherlands B.V.**
**Corporate Intellectual Property**
**P.O. Box 324**
**5500 AH Veldhoven (NL)**

(56) References cited:
**WO-A1-2020/193095   WO-A1-2021/032448**
**US-A1- 2018 284 597**

• **WEISBUCH FRANÇOIS: "Introducing etch kernels for efficient pattern sampling and etch bias prediction", JOURNAL OF MICRO/ NANOLITHOGRAPHY, MEMS, AND MOEMS, vol. 17, no. 01, 6 March 2018 (2018-03-06), US, pages 1, XP055964380, ISSN: 1932-5150, DOI: 10.1117/ 1.JMM.17.1.013505**

# Description

TECHNICAL FIELD

The present disclosure relates generally to etching effect simulations associated with computational lithography.

BACKGROUND

A lithographic projection apparatus can be used, for example, in the manufacture of integrated circuits (ICs). A patterning device (e.g., a mask) may include or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices can be found in, for example, US 6,046,792.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish the individual layer of the device. If several layers are required in the device, then the whole procedure, or a variant thereof, is repeated for each layer. Eventually, a device will be present in each target portion on the substrate. These devices are then separated from one another by a technique such as dicing or sawing, such that the individual devices can be mounted on a carrier, connected to pins, etc.

Manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

Lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced. At the same time, the number of functional elements, such as transistors, per device has been steadily increasing, following a trend commonly referred to as "Moore"s law." At the current state of technology, layers of devices are manufactured using lithographic projection apparatuses that project a design layout onto a substrate using illumination from a deep-ultraviolet illumination source, creating individual functional elements having dimensions well below 100 nm, i.e. less than half the wavelength of the radiation from the illumination source (e.g., a 193 nm illumination source).

This process in which features with dimensions smaller than the classical resolution limit of a lithographic projection apparatus are printed, is commonly known as low-k1 lithography, according to the resolution formula CD = k1×λ/NA, where λ is the wavelength of radiation employed (currently in most cases 248nm or 193nm), NA is the numerical aperture of projection optics in the lithographic projection apparatus, CD is the "critical dimension"-generally the smallest feature size printed-and k1 is an empirical resolution factor. In general, the smaller k1 the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET).

SUMMARY

Etch effects are often taken into consideration during OPC and/or other processes (e.g., for patterning process optimization and/or other purposes). A simulation model can be used to predict etch effects such as etch bias, for example. The etch bias may be a (e.g., predicted) bias from a resist profile used to derive an etch profile of features processed on a substrate (e.g., wafer) as a result of etching. Prior simulation models include different terms configured to simulate etch bias. However, prior simulation models typically assume that an etch bias direction is uniform, e.g., perpendicular to a given location on a wafer (substrate) pattern contour, see for example Weisbuch François: "Introducing etch kernels for efficient pattern sampling and etch bias prediction",Journal of Micro/Nanolithography, MEMS, and MOEMS, vol. 17, no. 01, 6 March 2018 (2018-03-06), page 1, XP055964380,US ISSN: 1932-5150, DOI: 10.1117/1.JMM.17.1.013505. According to embodiments of the present disclosure, systems and methods account for the influence of curvatures of contours in a wafer pattern on the etch bias direction. In some embodiments, the curvatures are in-plane curvatures.

Thus, according to the invention, there is provided a non-transitory computer readable medium having instructions thereon to determine an etch effect to be taken into consideration during optical proximity correction and/or other patterning process optimization, the instructions when executed by a computer, cause the computer to receive a representation of a first contour of a substrate pattern; determine a curvature of the first contour; determine an etch bias direction based on the curvature; and use a simulation model to determine an etch effect such as etch bias and/or other etch effects based on the etch bias direction resulting from an etching process on the substrate pattern.

In some embodiments, the curvature is a curvature at a given location (e.g., a point, a linear segment, a curved segment, etc.) on the first contour. The etch bias direction is for the given location and is determined based on the curvature at the given location. In some embodiments, the etch bias direction at the given location is further based on the curvature(s) at one or more adjacent locations along the first contour in proximity to the given location.

In some embodiments, the etch bias direction for the given location on the first contour is determined based on a combination of curvatures at the one or more adjacent locations along the first contour with the curvature at the given location.

In some embodiments, the combination is weighted based on the curvatures.

In some embodiments, the etch bias direction for a given location on the first contour is determined further based on a combination of the normal direction of the first contour at the given location and normal directions at one or more adjacent locations along the first contour in proximity to the given location.

In some embodiments, the etch bias direction for the given location on the first contour is determined based on a combination of the normal directions at the one or more adjacent locations along the first contour with the normal direction of the first contour at the given location. In some embodiments, the combination is weighted based on the normal directions.

In some embodiments, the instructions further cause the computer to determine an etch bias value based on the representation of the first contour of the substrate pattern, and use the simulation model to determine the etch effect based on the etch bias direction and the etch bias value at the location.

In some embodiments, the instructions further cause the computer to determine curvatures, etch bias values, and etch bias directions at a multiple locations along the first contour; and use the simulation model to determine the etch effect based on the curvatures, etch bias values, and etch bias directions at the multiple locations along the first contour.

In some embodiments, the etch effect is a change in the first contour of the substrate pattern caused by etching, which produces an after etch substrate pattern, and using the simulation model to determine the etch effect comprises determining one or more locations on the after etch substrate pattern based on the etch bias direction.

In some embodiments, the representation of the first contour is received electronically, and the representation of the first contour is a representation of a resist contour. In some embodiments, the representation of the first contour comprises a resist image.

In some embodiments, the instructions further cause the computer to determine an after etch contour and/or an after etch image based on the etch effect.

In some embodiments, using the simulation model to determine the etch effect based on the etch bias direction comprises determining a second contour based on the first contour and determined etch bias directions of locations on the first contour.

In some embodiments, the first contour is a resist contour and the second contour is an after etch contour.

In some embodiments, determining the etch bias direction is performed using an algorithm comprising a combination term, a filtering term, a curvature term, and a calibration term.

In some embodiments, the simulation model is a vector based effective etch bias model.

In some embodiments, using the simulation model to determine the etch effect comprises, in a calibration flow, determining the etch bias direction at each location on a gage contour of the substrate pattern.

In some embodiments, using the simulation model to determine the etch effect based on the etch bias direction for an etching process simulated using the substrate pattern comprises, in a model application flow, biasing each vertex of a resist contour with a bias vector based on the etch bias direction to determine an after etch contour.

In some embodiments, using the simulation model to determine the etch effect based on the etch bias direction for an etching process simulated using the substrate pattern comprises, for optical proximity correction, using a resist contour and an etch bias direction at each location on the resist contour, and determining an after etch contour, which can be used to estimate an etch signal for the optical proximity correction.

In some embodiments, the etch effect is determined based on an etch bias value and the etch bias direction, and wherein the etch bias value and/or the etch bias direction are configured to be provided to a cost function to facilitate determination of costs associated with individual patterning process variables.

In some embodiments, the curvature of the first contour is determined based on one or more derivatives of an equation that represents the first contour.

According to another embodiment, there is provided a non-transitory computer readable medium having instructions thereon, the instructions when executed by a computer, causing the computer to execute a simulation model for determining a change in a contour of a substrate pattern caused by etching, based on a determined etch bias direction. The etch bias direction is configured to be used to determine the change in the contour of the substrate pattern to enhance an accuracy of a patterning process relative to prior patterning processes. The instructions cause operations comprising: receiving a representation of the substrate pattern, wherein the representation comprises the contour in the substrate pattern; determining an etch bias value for a location on the contour of the substrate pattern; determining a curvature of the contour of the substrate pattern at the location; determining an etch bias direction based on the curvature; inputting the etch bias value and the etch bias direction to the simulation model; and outputting, based on the simulation model, an after etch contour for the substrate pattern. The after etch contour comprises the change in the contour of the substrate pattern caused by etching. The after etch contour from the simulation model is configured to be used in a cost function to facilitate determination of costs associated with individual patterning process variables. The costs associated with individual patterning variables are configured to be used to facilitate an optimization of the patterning process.

In some embodiments, the representation of the substrate pattern comprises a resist image and the contour is a resist contour.

In some embodiments, using the simulation model to determine the after etch contour based on the etch bias direction comprises determining a location on an after etch pattern based on the etch bias direction.

In some embodiments, determining the etch bias direction is performed using an algorithm comprising a combination term, a filtering term, a curvature term, and a calibration term.

In some embodiments, the simulation model is a vector based effective etch bias model.

BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 illustrates a block diagram of various subsystems of a lithographic projection apparatus, according to an embodiment of the present disclosure.
Figure 2 illustrates an exemplary flow chart for simulating lithography in a lithographic projection apparatus, according to an embodiment of the present disclosure.
Figure 3 illustrates an etch edge placement error comparison between an image edge placement error and a contour edge placement error (for a one dimensional region of a pattern, where the etch biasing directions are defined to be perpendicular to corresponding locations on a resist contour), according to an embodiment of the present disclosure.
Figure 4 illustrates another etch edge placement error comparison between an image edge placement error and a contour edge placement error (but for a two dimensional region of a pattern, again where the etch biasing directions are defined to be perpendicular to corresponding locations on a resist contour), according to an embodiment of the present disclosure.
Figure 5 illustrates an example of an unrealistic predicted contour for a feature of a pattern, where the unrealistic nature of the prediction is caused by etch biasing directions that are defined to be normal to corresponding locations on a contour, according to an embodiment of the present disclosure.
Figure 6 illustrates a present method, according to an embodiment of the present disclosure.
Figure 7 illustrates determination of a curvature at a given location in a contour in a substrate (e.g., wafer) pattern, according to an embodiment of the present disclosure.

Figure 8 illustrates a generalized example process flow using the present systems and methods, according to an embodiment of the present disclosure.

Figure 9 illustrates an example of an etch contour generated by an existing effective etch bias model (e.g., using defined normal etch bias directions) based on resist contour compared to etch contours generated by (or determined based on output from) three different configurations of a present vector based effective etch bias model (VEEB), which uses etch bias directions determined for individual locations on resist contour as described herein, according to an embodiment of the present disclosure.

Figure 10 is a block diagram of an example computer system, according to an embodiment of the present disclosure.

Figure 11 is a schematic diagram of a lithographic projection apparatus, according to an embodiment of the present disclosure.

Figure 12 is a schematic diagram of another lithographic projection apparatus, according to an embodiment of the present disclosure.

Figure 13 is a detailed view of a lithographic projection apparatus, according to an embodiment of the present disclosure.

Figure 14 is a detailed view of the source collector module of a lithographic projection apparatus, according to an embodiment of the present disclosure.

## DETAILED DESCRIPTION

A simulation model can be used to predict after etch pattern feature profiles (e.g., contours) based on etch effects such as etch bias, for example. Etch bias may be a (e.g., predicted) bias from a resist profile used to derive an etch profile of features processed on a substrate (e.g., wafer) as a result of etching. Etch bias comprises the change in a given substrate pattern feature dimension between an after development inspection (ADI) and an after etch inspection (AEI). Typically, a simulation model such as an effective etch bias (EEB) model simulates an etch bias distribution (e.g., in the form of an etch bias map) for a wafer pattern. The etch bias map can be used to determine after etch contours of pattern features with given resist contours. Prior simulation models include different terms configured to simulate various kinds of etch effects, including etch bias. However, prior simulation models do not account for the influence of in-plane curvatures of contours in a wafer pattern on etch bias directions. Prior simulation models typically define an etch bias direction as perpendicular to a given location on a wafer (substrate) pattern contour.

Advantageously, the present disclosure describes systems, models, and manufacturing processes (methods) for determining etch effects for a pattern on a substrate (e.g., wafer) based on etch bias directions which are determined by taking into account curvatures or curvature variations of contours in the pattern. For example, an etch effect may be defined by an etch magnitude and a etch bias direction (e.g., which is not simply defined to be normal in the present systems and methods).

As described herein, a representation of a pattern includes a given contour in the pattern (e.g., which can be a resist contour). The curvature of the contour of the pattern is determined. An etch bias direction is determined based on the shape and the curvature of the contour and inputted to a simulation model. Etch effects for the contour in the pattern are determined by the simulation model. Among other possible uses, the etch effects predicted from the simulation model may be used to determine after etch feature contours, used for process optimization, and/or used for other purposes. The after etch feature contours and/or the costs associated with individual patterning variables may be used to facilitate an optimization of a patterning process, for example.

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "projection optics," as used herein, should be broadly interpreted as encompassing various types of optical systems, including refractive optics, reflective optics, apertures and catadioptric optics, for example. The term "projection optics" may also include components operating according to any of these design types for directing, shaping, or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the (e.g., semiconductor) patterning device, and/or optical components for shaping, adjusting and/or projecting the radiation after the radiation passes the patterning device. The projection optics generally exclude the source and the patterning device.

A (e.g., semiconductor) patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. The design rules may include and/or specify specific parameters, limits on and/or ranges for parameters, and/or other information. One or more of the design rule limitations and/or parameters may be referred to as a "critical dimension" (CD). A critical dimension of a device can be defined as the smallest width of a line or hole or the smallest space between two lines or two holes, or other features. Thus, the CD determines the overall size and density of the designed device. One of the goals in device fabrication is to faithfully reproduce the original design intent on the substrate (via the patterning device).

The term "mask" or "patterning device" as employed in this text may be broadly interpreted as referring to a generic semiconductor patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include a programmable mirror array and a programmable LCD array.

An example of a programmable mirror array can be a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means. An example of a programmable LCD array is given in U.S. Patent No. 5,229 872.

As used herein, the term "patterning process" generally means a process that creates an etched substrate by the application of specified patterns of light as part of a lithography process. However, "patterning process" can also include (e.g., plasma) etching, as many of the features described herein can provide benefits to forming printed patterns using etch (e.g., plasma) processing.

As used herein, the term "pattern" means an idealized pattern that is to be etched on a substrate (e.g., wafer).

As used herein, a "printed pattern" means the physical pattern on a substrate that was etched based on a target pattern. The printed pattern can include, for example, troughs, channels, depressions, edges, or other two and three dimensional features resulting from a lithography process.

As used herein, the term "prediction model", "process model", "electronic model", and/or "simulation model" (which may be used interchangeably) means a model that includes one or more models that simulate a patterning process. For example, a model can include an optical model (e.g., that models a lens system/projection system used to deliver light in a lithography process and may include modelling the final optical image of light that goes onto a photoresist), a resist model (e.g., that models physical effects of the resist, such as chemical effects due to the light), an OPC model (e.g., that can be used to make target patterns and may include sub-resolution resist features (SRAFs), etc.), an etch (or etch bias) model (e.g., that simulates the physical effects of an etching process on a printed wafer pattern), and/or other models.

As used herein, the term "calibrating" means to modify (e.g., improve or tune) and/or validate an electronic model.

A patterning system may be a system comprising any or all of the components described above, plus other components configured to performing any or all of the operations associated with these components. A patterning system may include a lithographic projection apparatus, a scanner, systems configured to apply and/or remove resist, etching systems, and/or other systems, for example.

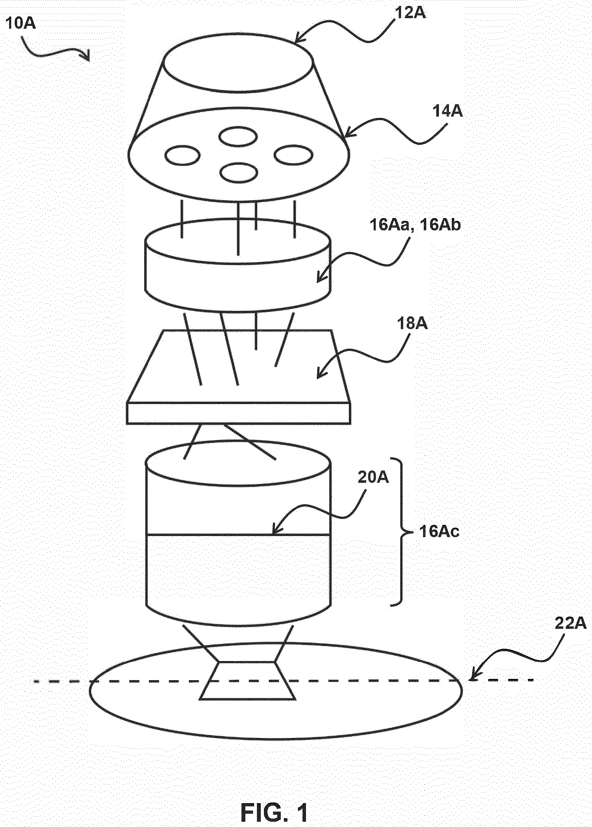

As an introduction, Figure 1 illustrates a diagram of various subsystems of an example lithographic projection apparatus 10A. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, for example, define the partial coherence (denoted as sigma) and which may include optics components 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin($\Theta_{max}$), wherein n is the refractive index of the media between the substrate and the last element of the projection optics, and $\Theta_{max}$ is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image. The resist model is related to properties of the resist layer (e.g., effects of chemical processes which occur during exposure, post-exposure bake (PEB) and development). Optical properties of the lithographic projection apparatus (e.g., properties of the illumination, the patterning device, and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251.

It may be desirable to use one or more tools to produce results that, for example, can be used to design, control, monitor, etc. the patterning process. One or more tools used in computationally controlling, designing, etc. one or more aspects of the patterning process, such as the pattern design for a patterning device (including, for example, adding sub-resolution assist features or optical proximity corrections), the illumination for the patterning device, etc., may be provided. Accordingly, in a system for computationally controlling, designing, etc. a manufacturing process involving patterning, the manufacturing system components and/or processes can be described by various functional modules and/or models. In some embodiments, one or more electronic (e.g., mathematical, parameterized, etc.) models may be provided that describe one or more steps and/or apparatuses of the patterning process (e.g., etching). In some embodiments, a simulation of the patterning process can be performed using one or more electronic models to simulate how the patterning process forms a patterned substrate using a pattern provided by a patterning device.

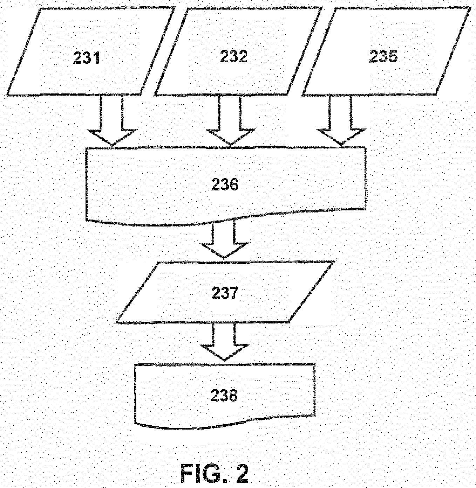

An exemplary flow chart for simulating lithography in a lithographic projection apparatus is illustrated in Figure 2. An illumination model 231 represents optical characteristics (including radiation intensity distribution and/or phase distribution) of the illumination. A projection optics model 232 represents optical characteristics (including changes to the radiation intensity distribution and/or the phase distribution caused by the projection optics) of the projection optics. A design layout model 235 represents optical characteristics (including changes to the radiation intensity distribution and/or the phase distribution caused by a given design layout) of a design layout, which is the representation of an arrangement of features on or formed by a patterning device. An aerial image 236 can be simulated using the illumination model 231, the projection optics model 232, and the design layout model 235. A resist image 238 can be simulated from the aerial image 236 using a resist model 237. Simulation of lithography can, for example, predict contours and/or CDs in the resist image.

More specifically, illumination model 231 can represent the optical characteristics of the illumination that include, but are not limited to, NA-sigma ($\sigma$) settings as well as any particular illumination shape (e.g. off-axis illumination such as annular, quadrupole, dipole, etc.). The projection optics model 232 can represent the optical characteristics of the of the projection optics, including, for example, aberration, distortion, a refractive index, a physical size or dimension, etc. The design layout model 235 can also represent one or more physical properties of a physical patterning device, as described, for example, in U.S. Patent No. 7,587,704. Optical properties associated with the lithographic projection apparatus (e.g., properties of the illumination, the patterning device, and the projection optics) dictate the aerial image. Since the patterning device used in the lithographic projection apparatus can be changed, it is desirable to separate the optical properties of the patterning device from the optical properties of the rest of the lithographic projection apparatus including at least the illumination and the projection optics (hence design layout model 235).

The resist model 237 can be used to calculate the resist image from the aerial image, an example of which can be found in U.S. Patent No. 8,200,468. The resist model is typically related to properties of the resist layer (e.g., effects of chemical processes which occur during exposure, post-exposure bake and/or development).

One of the objectives of the full simulation is to accurately predict, for example, edge placements, aerial image intensity slopes and/or CDs, which can then be compared against an intended design. The intended design is generally defined as a pre-OPC design layout which can be provided in a standardized digital file format such as GDS, GDSII, OASIS, or other file formats.

From the design layout, one or more portions may be identified, which are referred to as "clips." In an embodiment, a set of clips is extracted, which represents the complicated patterns in the design layout (typically about 50 to 1000 clips, although any number of clips may be used). As will be appreciated by those skilled in the art, these patterns or clips represent small portions (e.g., circuits, cells, etc.) of the design and especially the clips represent small portions for which particular attention and/or verification is needed. In other words, clips may be the portions of the design layout or may be similar or have a similar behavior of portions of the design layout where critical features are identified either by experience (including clips provided by a customer), by trial and error, or by running a full-chip simulation. Clips often contain one or more test patterns or gauge patterns. An initial larger set of clips may be provided a priori by a customer based on known critical feature areas in a design layout which require particular image optimization. Alternatively, in another embodiment, the initial larger set of clips may be extracted from the entire design layout by using an automated (such as, machine vision) or manual algorithm that identifies the critical feature areas.

For example, the simulation and modeling can be used to configure one or more features of the patterning device pattern (e.g., performing optical proximity correction), one or more features of the illumination (e.g., changing one or more characteristics of a spatial / angular intensity distribution of the illumination, such as change a shape), and/or one or more features of the projection optics (e.g., numerical aperture, etc.). Such configuration can be generally referred to as, respectively, mask optimization, source optimization, and projection optimization. Such optimization can be performed on their own, or combined in different combinations. One such example is source-mask optimization (SMO), which involves the configuring of one or more features of the patterning device pattern together with one or more features of the illumination. The optimization techniques may focus on one or more of the clips. The optimizations may use the machine learning model described herein to predict values of various parameters (including images, etc.).

Similar modelling techniques may be applied for optimizing an etching process, for example, and/or other processes. In some embodiments, illumination model 231, projection optics model 232, design layout model 235, resist model 237, and/or other models may be used in conjunction with an etch model, for example. For example, output from an after development inspection (ADI) model (e.g., included as some and/or all of design layout model 235, resist model 237, and/or other models) may be used to determine an ADI contour, which may be provided to an effective etch bias (EEB) model to generate a predicted after etch inspection (AEI) contour.

In some embodiments, an optimization process of a system may be represented as a cost function. The optimization process may comprise finding a set of parameters (design variables, process variables, etc.) of the system that minimizes the cost function. The cost function can have any suitable form depending on the goal of the optimization. For example, the cost function can be weighted root mean square (RMS) of deviations of certain characteristics (evaluation points) of the system with respect to the intended values (e.g., ideal values) of these characteristics. The cost function can also be the maximum of these deviations (i.e., worst deviation). The term "evaluation points" should be interpreted broadly to include any characteristics of the system or fabrication method. The design and/or process variables of the system can be confined to finite ranges and/or be interdependent due to practicalities of implementations of the system and/or method. In the case of a lithographic projection apparatus, the constraints are often associated with physical properties and characteristics of the hardware such as tunable ranges, and/or patterning device manufacturability design rules. The evaluation points can include physical points on a resist image on a substrate, as well as non-physical characteristics such as one or more etching parameters, dose and focus, etc., for example.

In an etching system, as an example, a cost function (CF) may be expressed as

$$CF(z_1, z_2, \cdots, z_N) = \sum_{p=1}^{P} w_p f_p^2(z_1, z_2, \cdots, z_N)$$

where $(z_1, z_2, \cdots, z_N)$ are N design variables or values thereof, and $f_p(z_1, z_2, \cdots, z_N)$ can be a function of the design variables $(z_1, z_2, \cdots, z_N)$ such as a difference between an actual value and an intended value of a characteristic for a set of values of the design variables of $(z_1, z_2, \cdots, z_N)$. In some embodiments, $w_p$ is a weight constant associated with $f_p(z_1, z_2, \cdots, z_N)$. For example, the characteristic may be a position of an edge of a pattern, measured at a given point on the edge. Different $f_p(z_1, z_2, \cdots, z_N)$ may have different weight $w_p$. For example, if a particular edge has a narrow range of permitted positions, the weight $w_p$ for the $f_p(z_1, z_2, \cdots, z_N)$ representing the difference between the actual position and the intended position of the edge may be given a higher value. $f_p(z_1, z_2, \cdots, z_N)$ can also be a function of an interlayer characteristic, which is in turn a function of the design variables $(z_1, z_2, \cdots, z_N)$. Of course, $CF(z_1, z_2, \cdots, z_N)$ is not limited to the form in the equation above and $CF(z_1, z_2, \cdots, z_N)$ can be in any other suitable form.

The cost function may represent any one or more suitable characteristics of the etching system, etching process, lithographic apparatus, lithography process, or the substrate, for instance, focus, CD, image shift, image distortion, image rotation, stochastic variation, throughput, local CD variation, process window, an interlayer characteristic, or a combination thereof. In some embodiments, the cost function may include a function that represents one or more characteristics of a resist image. For example, $f_p(z_1, z_2, \cdots, z_N)$ can be simply a distance between a point in the resist image to an intended position of that point (i.e., edge placement error $EPE_p(z_1, z_2, \cdots, z_N)$ after etching, for example, and/or some other process. The parameters (e.g., design variables) can include any adjustable parameter such as an adjustable parameter of the etching system, the source, the patterning device, the projection optics, dose, focus, etc.

The parameters (e.g., design variables) may have constraints, which can be expressed as $(z_1, z_2, \cdots, z_N) \in Z$, where $Z$ is a set of possible values of the design variables. One possible constraint on the design variables may be imposed by a desired throughput of the lithographic projection apparatus. Without such a constraint imposed by the desired throughput, the optimization may yield a set of values of the design variables that are unrealistic. Constraints should not be interpreted as a necessity.

In some embodiments, illumination model 231, projection optics model 232, design layout model 235, resist model 237, an etch model, and/or other models associated with and/or included in an integrated circuit manufacturing process may be an empirical and/or other simulation model that performs at least some of the operations of the method described herein. The empirical model may predict outputs based on correlations between various inputs (e.g., one or more characteristics of a pattern such as curvature, one or more characteristics of the patterning device, one or more characteristics of the illumination used in the lithographic process such as the wavelength, etc.).

As an example, the empirical model may be a machine learning model and/or any other parameterized model. In some embodiments, the machine learning model (for example) may be and/or include mathematical equations, algorithms, plots, charts, networks (e.g., neural networks), and/or other tools and machine learning model components. For example, the machine learning model may be and/or include one or more neural networks having an input layer, an output layer, and one or more intermediate or hidden layers. In some embodiments, the one or more neural networks may be and/or include deep neural networks (e.g., neural networks that have one or more intermediate or hidden layers between the input and output layers).

As an example, the one or more neural networks may be based on a large collection of neural units (or artificial neurons). The one or more neural networks may loosely mimic the manner in which a biological brain works (e.g., via large clusters of biological neurons connected by axons). Each neural unit of a neural network may be connected with many other neural units of the neural network. Such connections can be enforcing or inhibitory in their effect on the activation state of connected neural units. In some embodiments, each individual neural unit may have a summation function that combines the values of all its inputs together. In some embodiments, each connection (or the neural unit itself) may have a threshold function such that a signal must surpass the threshold before it is allowed to propagate to other neural units. These neural network systems may be self-learning and trained, rather than explicitly programmed, and can perform significantly better in certain areas of problem solving, as compared to traditional computer programs. In some embodiments, the one or more neural networks may include multiple layers (e.g., where a signal path traverses from front layers to back layers). In some embodiments, back propagation techniques may be utilized by the neural networks, where forward stimulation is used to reset weights on the "front" neural units. In some embodiments, stimulation and inhibition for the one or more neural networks may be freer flowing, with connections interacting in a more chaotic and complex fashion. In some embodiments, the intermediate layers of the one or more neural networks include one or more convolutional layers, one or more recurrent layers, and/or other layers.

The one or more neural networks may be trained (i.e., whose parameters are determined) using a set of training information. The training information may include a set of training samples. Each sample may be a pair comprising an input object (typically a vector, which may be called a feature vector) and a desired output value (also called the supervisory signal). A training algorithm analyzes the training information and adjusts the behavior of the neural network by adjusting the parameters (e.g., weights of one or more layers) of the neural network based on the training information. For example, given a set of N training samples of the form $\{(x_1, y_1), (x_2, y_2), \cdots, (x_N, y_N)\}$ such that $x_i$ is the feature vector of the i-th example and $y_i$ is its supervisory signal, a training algorithm seeks a neural network $g: X \rightarrow Y$, where X is the input space and Y is the output space. A feature vector is an n-dimensional vector of numerical features that represent some object (e.g., a simulated aerial image, a wafer design, a clip, etc.). The vector space associated with these vectors is often called the feature space. After training, the neural network may be used for making predictions using new samples.

In some embodiments, the present systems and methods include (or use) an empirical simulation model that comprises one or more algorithms. The one or more algorithms comprise one or more non-linear, linear, or quadratic functions representative of the physical parameters of an etching process. In some embodiments, the one or more algorithms comprise a curvature term configured to, alone or in combination with other algorithm terms, correlate curvatures with etch bias amounts and/or directions. In some embodiments, the empirical simulation model comprising the one or more algorithms may be a physical etch model. The physical etch model can be, be part of, and/or include a vector based effective etch bias (VEEB) model (e.g., as described below), a resist model (e.g., resist model 237) in combination with an etch bias model, and/or other models. This is further described below.

As one example practical application of the present disclosure, optical proximity correction involves adjusting a desired pattern and/or placing assist features around the desired pattern such that a difference between a predicted pattern and a desired pattern is reduced. Optical proximity correction often requires an optical model, a resist model, and an etch model for mask design optimization. The resist model is configured to generate a resist image. The etch model (e.g., an effective etch bias model) is configured to simulate etch effects and generate an etch contour determined based on a resist contour. In an embodiment, the etch model calculates after-etching-image (AEI) contours by directly biasing after development image (ADI) contours. During etch model calibration, an etch biasing value is determined and used to configure the model. The etch bias value (e.g., a scalar magnitude) is determined for a location of interest on a contour, but does not provide a corresponding etch bias direction. As a result, until now, the etch bias direction has been defined to be perpendicular (or normal) to the location of interest on the contour, when simulating an etch contour based on a resist contour.

For example, an etch bias is determined via an etch model. The etch model calculates the after-etching-image (AEI) contours by directly biasing an after development image (ADI) contours (as described above. A biasing direction of is defined to be perpendicular to the ADI contours. A biasing amount is variable, depending on an environment (e.g., a feature density of an ADI pattern and physical terms associated with the etching). For example, in certain circumstances, a positive bias amount moves the ADI contour outward while a negative bias amount moves the ADI contour inward. In other words, the etch bias can be positive, where the size of a pattern element is bigger before etching than after the etching, or it is negative, where the size is smaller before etching than after the etching.

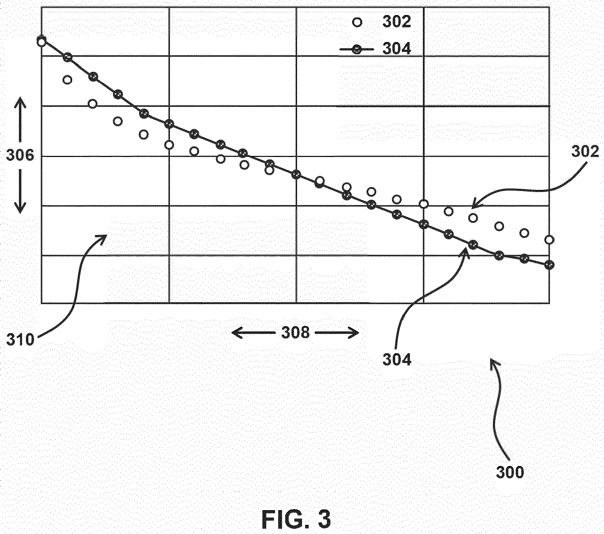

With existing technology, there can be an unexpected, non-physical, and/or otherwise less accurate non-linear modelling response for two dimensional patterns if a scalar etch bias map is used, because existing technology only provides etch bias values, without specifically determined corresponding etch bias directions. For example, during OPC for a one dimensional region of a pattern, etch biasing directions are defined to be perpendicular to corresponding locations on a resist contour (or computed locations based on a resist image), and similar to a resist image slope. Thus, an image edge placement error (EPE) response, for example, for OPC related simulation, is similar to a contour EPE. (EPE may be a distance between a location in an image to an intended position of that location, for example.) This is illustrated in Figure 3. For example, Figure 3 illustrates an etch EPE comparison 300 between an image EPE 302 and a contour EPE 304. Figure 3 illustrates comparison 300 between image EPE 302 and a contour EPE 304 on a etch EPE (nm) 306 versus offset value (nm) 308 graph 310. As shown in Figure 3, image EPE 302 and contour EPE 304 generally correspond to each other.

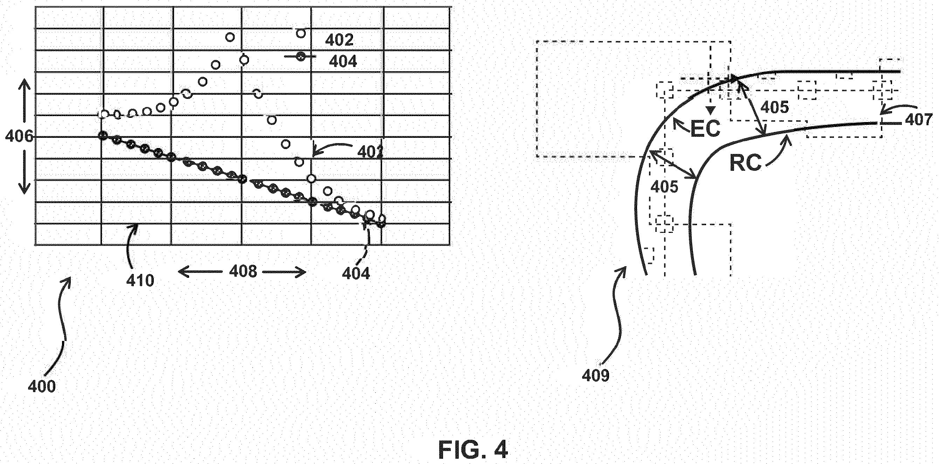

However, for large etch bias values for a region with a high curvature in the pattern, the assumption that the etch biasing directions are perpendicular to corresponding locations on the resist contour may cause the image EPE and the contour EPE to diverge. For example, a combination of normal directions (e.g., vectors) may point (e.g., in one or more directions) away from an evaluation location, such that the image EPE is not linear and/or robust. This is illustrated in Figure 4. Figure 4 illustrates another etch EPE comparison 400 between an image EPE 402 and a contour EPE 404 for large etch bias values 405 (e.g., between resist contour (RC) and etch contour (EC)) for a two dimensional region 407 of a pattern 409. Figure 4 illustrates comparison 400 between image EPE 402 and contour EPE 404 on a etch EPE (nm) 406 versus offset value (nm) 408 graph 410. However, as shown in Figure 4, image EPE 402 and contour EPE 404 do not correspond to each other.

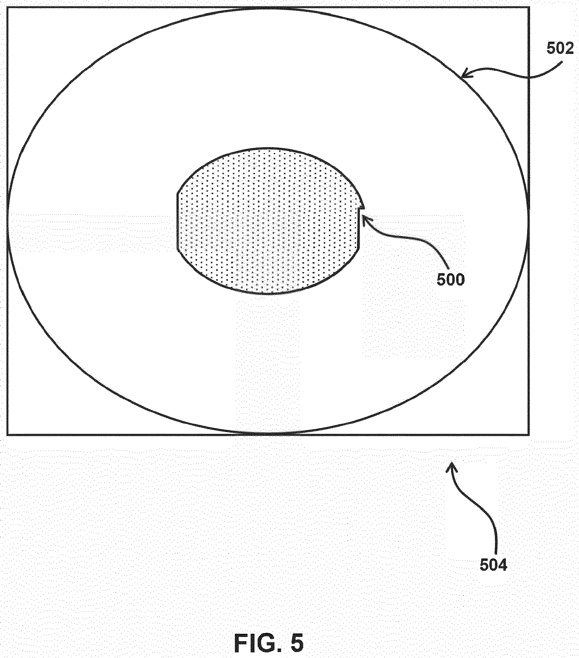

In addition, with existing technology, one or more of the defined normal etch biasing directions may intersect, which can produce unexpected, non-physical, and/or otherwise unrealistic simulated contours. Figure 5 illustrates an example of an unrealistic simulated contour 500 for a contour 502 of a pattern 504, where the unrealistic nature of the simulation is caused by etch biasing directions that are defined to be normal to corresponding locations on contour 502. As shown in Figure 5, unrealistic simulated contour 500 includes a sharp corner that would not have been predicted had the model not relied on normal etch bias direction assumptions. This may also occur because, with existing technology, the etch bias model is calibrated based on etch bias values, instead of etch bias values in combination with the edge placement error between an etch contour and a resist contour, essentially not taking a final etch contour into consideration.

In contrast to existing technology, the present disclosure describes systems, models, and manufacturing processes (methods) for determining etch effects for a pattern on a substrate (e.g., wafer) based on etch bias directions such that etch simulation is performed by a vector based (e.g., etch bias direction aware) effective etch bias model. Etch effects for patterns on a substrate (e.g., wafer) are determined based on etch bias directions determined for different curvatures of contours in the pattern. Use of etch bias directions in etching simulations enhances an accuracy of after etch contour determinations, and in turn enhance an overall accuracy of a patterning process relative to prior patterning processes.

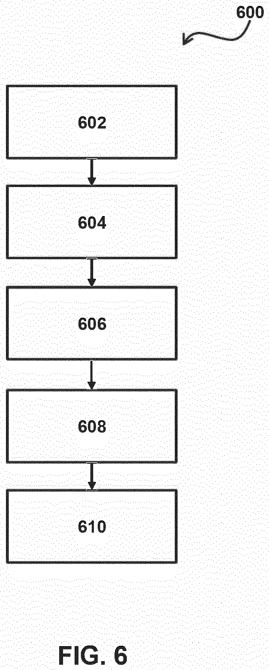

Figure 6 illustrates an exemplary method 600 according to an embodiment of the present disclosure. In some embodiments, method 600 comprises receiving 602 a representation of a contour in a substrate pattern, determining 604 a curvature of the contour, determining 606 an etch bias direction based on the curvature; and inputting 608 the etch bias direction to a simulation model to determine an etch effect based on the etch bias direction for an etching process on the substrate pattern. In some embodiments, method 600 includes using 610 the etch effect to predict after etch feature contours in a substrate (wafer) pattern, in a cost function to facilitate determination of costs associated with individual patterning process variables, and/or in other operations.

In some embodiments, a non-transitory computer readable medium stores instructions which, when executed by a computer, cause the computer to execute one or more of operations 602-610, and/or other operations. The operations of method 600 are intended to be illustrative. In some embodiments, method 600 may be accomplished with one or more additional operations not described, and/or without one or more of the operations discussed. For example, operation 610 and/or other operations may be optional. Additionally, the order in which the operations of method 600 are illustrated in Figure 6 and described herein is not intended to be limiting.

At operation 602, a representation of a (e.g., first) contour in a substrate pattern is received. The representation comprises the contour in the pattern and/or other information. For example, the representation may include information describing the geometrical shape of the contour in the pattern and/or information related to the geometrical shape. The geometrical shape of the contour in the pattern may be a two dimensional geometrical shape, for example. The received representation includes data that describes the characteristics of the contour (e.g., such as X-Y dimensional data points, a mathematical equation that describes the geometrical shape, etc.), processing parameters associated with the contour, and/or other data. In some embodiments, the representation of the pattern comprises inspection results from an after development inspection (ADI) for the pattern, a model of the contour in the pattern, and/or other information. The inspection results from the after development inspection for the pattern may be obtained from a scanning electron microscope, an optical metrology tool, and/or other sources. In some embodiments, the contour is obtained from a resist model (e.g., as shown in Figure 2 and described above), an optical model (e.g., as shown in Figure 2 and described above), and/or other modelling sources. For example, in some embodiments, a contour may be a resist contour shown in a resist image. The resist contour and/or the resist image may be generated by a resist model, for example.

The representation may be received electronically from one or more other portions of the present system (e.g., from a different processor, or from a different portion of a single processor), from a remote computing system not associated with a present system, and/or from other sources. The representation may be received wirelessly and/or via wires, via a portable storage medium, and/or from other sources. The representation may be uploaded and/or downloaded from another source, such as cloud storage for example, and/or received in other ways.

At operation 604, a curvature of the contour in the substrate pattern is determined. The curvature is an in-plane curvature (e.g., a two dimensional curve). Curvature can be an indication of the activation energy in an etching process at a given localized etch position, which influences etch effects. The curvature can be determined based on a slope of the contour in the pattern, a maximum or a minimum in the contour in the pattern, and/or other information. The slope, the maximum, and/or the minimum may be determined based on first and or second derivatives of the contour, for example. In some embodiments, the curvature is determined by a ratio between the second derivative and the first derivative and/or other mathematical operations. It should be noted that although the present disclosure often describes determining a single curvature, curvature may be determined at one or more locations (e.g., given locations) along the contour.

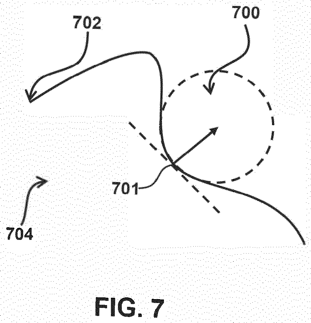

By way of a non-limiting example, Figure 7 illustrates determination of a curvature 700 at a given point / location 701 in a contour 702 in a substrate (e.g., wafer) pattern 704. As shown in Figure 7, curvature 700 is an in-plane curvature (e.g., for a two dimensional contour 702). In some embodiments, curvature 700 is determined based on a slope (e.g., an inclined or declined portion) of contour 702 in pattern 704, a maximum or a minimum (e.g., an inflection point) in contour 702 in pattern 704, and/or other information. The slope, the maximum, and/or the minimum may be determined based on first and or second derivatives of contour 702, for example. Curvature 700 may also and/or instead be determined by a ratio between the second derivative and the first derivative. In some embodiments, it may be possible to determine curvature using other combinations of the first derivative, the second derivative, and/or various other constants and equation terms. These embodiments should be considered to be within the scope of the present invention.

Returning to Figure 6, at operation 606, an etch bias direction is determined based on the curvature and/or other information. An etch bias direction comprises a direction a given point or location on a contour moves as a result of an etching process on the contour. In some embodiments, the curvature is a curvature at a given point or location on a (e.g., first) contour (e.g., as described above), and the etch bias direction is for the given location. This etch bias direction is determined based on the curvature at the given location, based on a curvatures at one or more adjacent locations along the (first) contour in proximity to the given location, and/or based on other information. For example, in some embodiments, the etch bias direction for a given location on a first contour is determined based on a combination of curvatures at one or more adjacent locations along the first contour with the curvature at the given location. In some embodiments, the combination is weighted based on the curvatures.

In some embodiments, the etch bias direction for a given location on the (e.g., first) contour is determined based on a normal direction of the first contour at the given location and/or normal directions at one or more adjacent locations along the first contour in proximity to the given location. For example, in some embodiments, the etch bias direction for the given location on the first contour is determined based on a combination of the normal directions at the one or more adjacent locations along the first contour with the normal direction of the first contour at the given location. In some embodiments, the combination is weighted based on the normal directions.

In some embodiments, determining the etch bias direction is performed using one or more algorithms. As an example, such an algorithm may comprise a combination term, a filtering term, a curvature term, a calibration term, and/or other terms. In some embodiments, the algorithm includes a term for a curvature at a location on a resist contour, and determines the etch bias direction for that location based on a weighted integral of adjacent normal directions (for adjacent locations on the resist contour). This contrasts with simply using the normal direction at the location as in prior etch models (e.g., as described above). Instead, the algorithm considers the effect of the contour geometry shape, and includes it empirically into the algorithm. This results in an accurately modeled physical bias direction for the resist contour, especially in regions with high curvature.

An algorithm can be used to determine etch bias directions for curvatures at different locations on a contour. In this example, the algorithm comprises a combination term of the normal directions (for the locations of interest on the contour), with a filtering function, a curvature-based weight function (e.g., for a location of interest on a contour), and a certain set of calibration parameters. The combination term is configured to account for adjacent normal directions for adjacent locations on the contour. A number of adjacent locations on both sides of the location of interest on the contour aggregated by the algorithm may be set by a user (e.g., entered and/or selected via a user interface as described below) based on prior process knowledge and/or other information, determined automatically (e.g., by one or more processors described herein) based on prior patterning process data and/or modeling, and/or determined in other ways. In some embodiments, the number of adjacent locations on both sides of the location of interest on the contour may be adjusted to enhance calibration of the algorithm (e.g., including more or less adjacent location may make the algorithm more or less accurate relative to actual physical effects produced by an etching process). The filtering term may be a Gaussian function, for example, and/or other functions. This function may be configured as a smoothing function, or a low pass filter, for example. In some embodiments, this function may include an adjustable range based term and/or other terms. The calibration term may comprise one or more adjustable parameters configured to be used to calibrate the algorithm to ensure the algorithm accurately determines etch bias directions. The one or more adjustable parameters may be used to weight the curvature term, the normal direction term, and/or other terms, for example.

In some embodiments, operation 606 comprises determining etch bias values, in addition to the etch bias directions, for one or more locations on a contour. An etch bias value is determined based on the representation of the (e.g., first) contour of the substrate pattern and/or other information. For example, as described above, in some embodiments, etch bias values are determined based on a corresponding resist image and the effective etch bias model. Determining etch bias values may include determining a variable (scalar) etch bias map, for example. In some embodiments, an etch bias value may be predicted by a trained machine learning model using a resist image as input.

Operation 608 comprises inputting an etch bias direction, an etch bias value, a curvature, and/or other information, for one or more locations on a contour, to a simulation model to determine etch effects based on the etch bias direction(s), the etch bias value(s), the curvature(s), and/or the other information, for an etching process on the substrate pattern. An etch effect is a change in the (first) contour of the substrate pattern caused by etching, which produces an after etch substrate pattern (e.g., a second contour). Using the simulation model to determine etch effects comprises determining one or more locations on the after etch substrate pattern based on an etch bias direction, an etch bias value, a curvature, and/or other information.

In some embodiments, operations 604-608 comprise determining curvatures, etch bias values, and etch bias directions at a multiple locations along a first contour, and using a simulation model to determine the etch effect based on the curvatures, etch bias values, and etch bias directions at multiple locations along the first contour. In some embodiments, using the simulation model to determine an etch effect based on an etch bias value, an etch bias direction, a curvature, and/or other information comprises determining a second contour based on a first contour and determined etch bias directions of curvatures at locations on the first contour. In some embodiments, the first contour is a resist contour and the second contour is an after etch contour, for example.

Inputting a curvature, an etch bias direction, and/or an etch bias value to the simulation model includes electronically sending, uploading, and/or otherwise providing the curvature, etch bias direction, and/or etch bias value to the simulation model. In some embodiments, the simulation model may be integrally programmed with the instructions that cause others of operations 602-610 (e.g., such that no "inputting" is required, and instead data simply flows directly to the simulation model). The simulation model is configured to predict the impact etch bias (values and/or) directions, curvature, and/or other information may have on local etch effects. The simulation model is configured to receive pattern contour curvatures, etch bias (values and/or) directions, and/or other information, and determine etch effects. An etch effect may be and/or include, for example, an etch bias having a magnitude and a direction.

In contrast to prior systems, the simulation model comprises a vector (or direction) based effective etch bias model. The simulation model comprises an etch bias direction component (e.g., determined based on the algorithm described above) that is not included in prior models. The simulation model comprises a correlation between etch effects and etch bias directions for corresponding curvatures. For example, the model is configured to correlate the etch bias directions with nearby etch effects for localized etch positions (e.g., locations on a contour). In some embodiments, the simulation model is configured to determine AEI contours based on ADI contours, for example, and/or other information.

The simulation model describes the physical parameters of an etch process as governed by chemistry/physics/mathematics principals in algorithm (e.g., with different terms for different physical parameters), machine learning, and/or other forms. In some embodiments, the simulation model comprises one or more machine learning components. In some embodiments, the simulation model comprises a physical or semi-physical etch (or etch bias) model component comprising one or more algorithms. In some embodiments, the simulation model is a combination of one or more machine learning components with one or more physical model algorithms.

The simulation model may have various components corresponding to different portions of an etch effect. For example, the simulation model may have a machine learning model component configured to predict etch bias values, an algorithm configured to determine etch bias directions, and/or other components. Collectively, the components of the simulation model can be and/or include the vector based effective etch bias (VEEB) model, a resist model in combination with an etch bias model, and/or other models.

In some embodiments, the simulation model comprises an algorithm (or more than one algorithm). In some embodiments, the simulation model comprises one or more of a non-linear algorithm, a linear algorithm, a quadratic algorithm, or a combination thereof, but can include any suitable arbitrary mathematical function representative of parameters of an etching process. For example, the function may have a power polynomial form, a piece-wise polynomial form, exponential forms, Gaussian forms, sigmoid forms, decision-tree type of forms, etc. These algorithms may include any number of parameters, weights, and/or other features, in any combination such that the function is configured to mathematically correlate curvatures, etch bias directions, and/or etch bias values with etch effects. In some embodiments, the simulation model comprises an algorithm with an etch bias direction term, an etch bias value term, a curvature term, and/or other terms. The etch bias direction term, the curvature term, and/or other terms may be combined with one or more additional terms in the algorithm to determine etch effects, for example. In some embodiments, the simulation model includes the algorithm described above, for example.

In some embodiments, the simulation model is a calibrated prediction model, for example. The simulation model is calibrated with curvature, etch bias direction, etch bias value, and/or other calibration data and corresponding etch effect calibration data. Calibration may include model generation, training, tuning, and/or other operations. Etch bias direction, etch bias value, and/or curvature calibration data and corresponding etch effect calibration data comprise known and/or otherwise previously determined data. The calibration data may be measured, simulated, and/or determined in other ways. In some embodiments, the calibration data is obtained by executing a full simulation model (e.g., where a full simulation model may include one or more of illumination model 231, projection optics model 232, design layout model 235, resist model 237, (all described above) and/or other models).

In some embodiments, the simulation model is calibrated by providing the calibration data to a base (simulation) model to obtain a prediction of the etch effect calibration data, and using the etch effect calibration data as feedback to update one or more configurations of the base model. For example, the one or more configurations of the simulation model may be updated based on a comparison between the etch effect calibration data and the prediction of the etch effect calibration data. The calibration data used for calibrating the simulation model may include pairs or sets of inputs (e.g., known etch bias directions) and corresponding known outputs (e.g., known corresponding etch effects). A calibrated simulation model can then be used to make predictions (e.g., on etch effects) based on new etch bias directions.

The present disclosure is not limited by any specific forms or algorithms of the simulation model. In some embodiments, as described above, the simulation model comprises a machine learning model component, an algorithm component, and/or other components. In some embodiments, calibrating the model comprises updating one or more configurations of the base model by tuning and/or otherwise adjusting one or more components of the simulation model. In some embodiments, tuning comprises adjusting one or more model parameters such that predicted etch effect data better matches, or better corresponds to, known etch effect data for corresponding etch bias directions. In some embodiments, tuning comprises training or re-training the model using additional calibration information comprising new and/or additional input / output calibration data pairs.

In some embodiments, the form of the simulation model (e.g., a machine learning component, a physical or semi-physical model component comprising one or more non-linear, linear, quadratic, and/or other algorithms, etc.), the parameters of an algorithm, weights, and/or other characteristics of the simulation model may be determined automatically based on the calibration described above, based on accuracy and runtime performance specifications provided by a user, based on manual entry and/or selection of information by a user through a user interface included in the present system, and/or by other methods. In some embodiments, the form of the simulation model, the parameters of the simulation model, and/or other characteristics of the simulation model may change with individual layers of a substrate (e.g., as processing parameters and/or other conditions that might cause and/or affect etching change), and/or based on other information. For example, different models may be calibrated for different layers of a substrate produced during semiconductor device manufacturing etching operations.

Operation 608 also comprises outputting etch effects from the simulation model. The etch effects are for the determined contour in the pattern. The etch effects may be outputted electronically to one or more other portions of the present system (e.g., to a different processor), to a remote computing system not associated with a present system, and/or to other locations. The etch effects may be outputted wirelessly and/or via wires, via a portable storage medium, and/or with other components. The etch effects may be uploaded and/or downloaded to another source, such as cloud storage for example, and/or outputted in other ways.

At operation 610, the etch effects are used in a cost function to facilitate determination of costs associated with individual patterning process variables and/or metrics. In some embodiments, an etch bias direction, and etch bias value, and/or other information may be used by the cost function directly, for example. The costs associated with individual patterning variables are configured to be used to facilitate an optimization of the patterning process. In some embodiments, costs associated with the individual patterning process variables are configured to be provided to an optimizer to facilitate (e.g. co-) optimization of an etching process, patterning systems (e.g., scanners), and/or other semiconductor manufacturing processes and/or systems. In general, an optimizer is a computer algorithm that finds the minimum of a given cost function. An optimizer may be a gradient based non-linear optimizer configured to co-determine multiple etching process variables, for example. An optimizer may be formed by one or more processors configured to balance different possible process variables (e.g., each within their own allowable ranges) against manufacturing capabilities or costs associated with different metrics (e.g., a critical dimension, a pattern placement error, an edge placement error, critical dimension asymmetry, a defect count associated with an etching process, and/or other metrics).

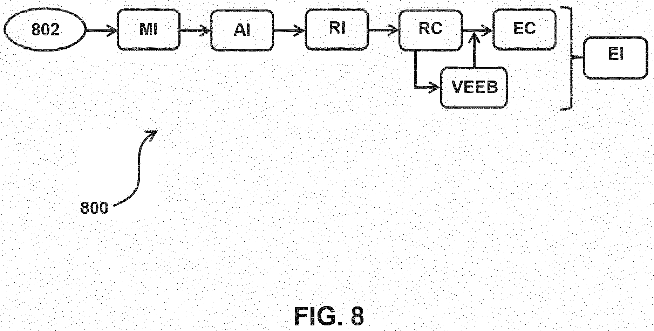

Figure 8 illustrates a generalized example process flow 800 using the present systems and methods. Continuing with the optical proximity correction (OPC) example above, an optical model, a resist model, and an etch model may be used for patterning process optimization. A mask image MI may be determined based on a pattern contour 802, which is itself defined by a .GDS, .GDSII, OASIS, and/or other electronic files. The optical model is configured to generate an aerial image AI determined based on the mask image and/or other information. The resist model is configured to generate a resist image RI based on the aerial image and/or other information, including at least one resist contour RC. The vector based effective etch bias (VEEB) simulation model described herein is configured to simulate etch effects and generate an (after) etch contour EC determined based on the resist contour, an etch bias direction determined as described herein, and/or other information. An (after) etch image EI may be determined based on the etch contour and/or other information, as shown in Figure 8.

In some embodiments, using the vector based effective etch bias simulation model to determine etch effects based on an etch bias direction, an etch bias value, a curvature, and/or other information for an etching process simulated using a substrate pattern (contour) comprises, in a calibration flow, determining the etch bias direction at each location on a gauge contour of the substrate pattern. In the calibration flow, with a bias direction on each resist contour vertex determined, for each gauge location, it is possible to determine the bias direction, the corresponding resist contour location, and the target etch bias value for a linear solver, for example.

In some embodiments, using the vector based effective etch bias simulation model to determine etch effects based on an etch bias direction, an etch bias value, a curvature, and/or other information for an etching process simulated using the substrate pattern comprises, in a model application flow, biasing locations (e.g., polygon vertices) of a resist contour with a etch bias direction vector based on the determined etch bias direction to determine the after etch contour. In the model application flow, with the bias value and direction of each resist contour vertex determined, biasing each resist contour vertex with a bias vector can produce a final etch contour, for example.

In some embodiments, using the vector based effective etch bias simulation model to determine etch effects based on an etch bias direction, an etch bias value, a curvature, and/or other information for an etching process simulated using the substrate pattern comprises, for optical proximity correction, using a resist contour and an etch bias direction at locations on the resist contour, and determining an after etch contour, which can be used to estimate an etch signal for the optical proximity correction. In OPC, with the resist contour, etch contour, and etch bias directions on the resist contour available, for each evaluation location, bias direction, the corresponding resist contour, and etch contour locations can be determined, for example. These values may be used to estimate the etch signal for OPC. Other flows are contemplated.

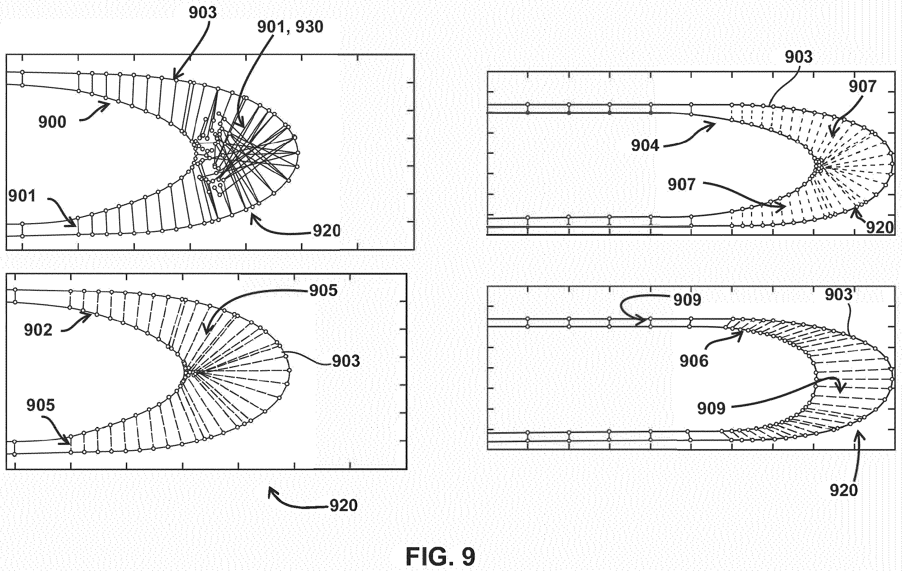

Figure 9 illustrates an example of an etch contour 900 generated by an existing effective etch bias model (e.g., using defined normal etch bias directions 901) based on resist contour 903 compared to etch contours 902, 904, 906 generated by (or determined based on output from) three different configurations of the present vector based effective etch bias model (VEEB), which uses etch bias directions 905, 907, and 909 determined for individual locations on resist contour 903 as described herein. The three different configurations of the present vector based effective etch bias model (VEEB) were successively determined as part of a simulation model calibration, and are tuned so that they have three different sets of model parameters (as described above).

In this example, the bias value (e.g., the distance between resist contour 903 and etch contours 900, 902, 904, or 906) is large, especially at the end 920 of contour 903, so at end 920, etch contour 900 shows self-intersection 930 of the normal directions after an existing biasing method (i.e., biasing along the normal direction.) Using the successive present vector based effective etch bias models, any intersected length of etch bias directions 905, 907, or 909 is reduced, and eventually fully eliminated (e.g., see etch bias directions 909).

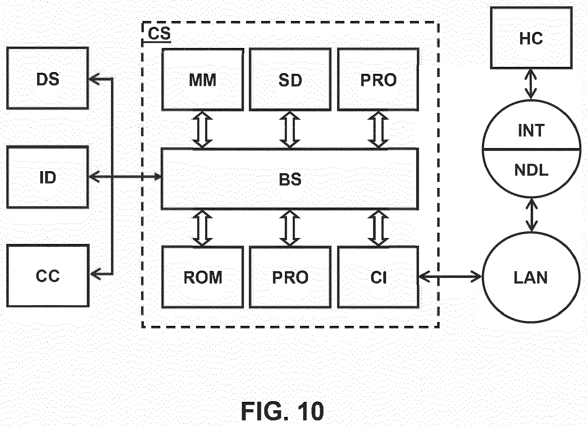

Figure 10 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" or "machine readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic, or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic, or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

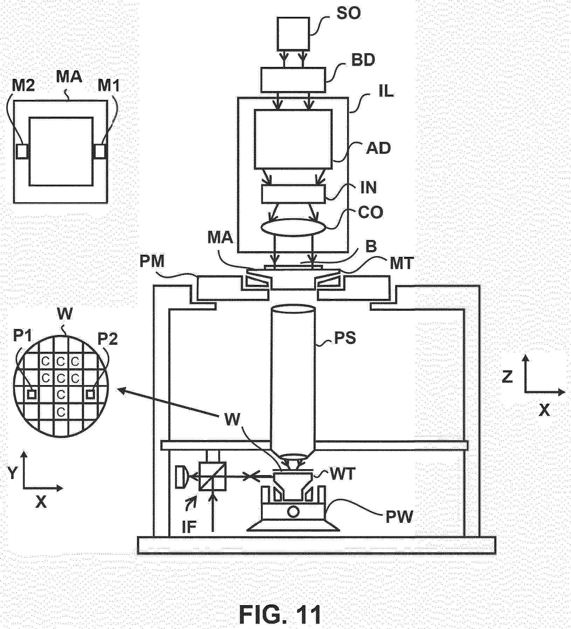

Figure 11 is a schematic diagram of a lithographic projection apparatus, according to an embodiment. The lithographic projection apparatus can include an illumination system IL, a first object table MT, a second object table WT, and a projection system PS. Illumination system IL, can condition a beam B of radiation. In this example, the illumination system also comprises a radiation source SO. First object table (e.g., a patterning device table) MT can be provided with a patterning device holder to hold a patterning device MA (e.g., a reticle), and connected to a first positioner to accurately position the patterning device with respect to item PS. Second object table (e.g., a substrate table) WT can be provided with a substrate holder to hold a substrate W (e.g., a resist-coated silicon wafer), and connected to a second positioner to accurately position the substrate with respect to item PS. Projection system (e.g., which includes a lens) PS (e.g., a refractive, catoptric or catadioptric optical system) can image an irradiated portion of the patterning device MA onto a target portion C (e.g., comprising one or more dies) of the substrate W. Patterning device MA and substrate W may be aligned using patterning device alignment marks M1, M2 and substrate alignment marks P1, P2, for example.

As depicted, the apparatus can be of a transmissive type (i.e., has a transmissive patterning device). However, in general, it may also be of a reflective type, for example (with a reflective patterning device). The apparatus may employ a different kind of patterning device for a classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander, or beam delivery system BD (comprising directing mirrors, the beam expander, etc.). for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

In some embodiments, source SO may be within the housing of the lithographic projection apparatus (as is often the case when source SO is a mercury lamp, for example), but that it may also be remote from the lithographic projection apparatus. The radiation beam that it produces may be led into the apparatus (e.g., with the aid of suitable directing mirrors), for example. This latter scenario can be the case when source SO is an excimer laser (e.g., based on KrF, ArF or F2 lasing), for example.

The beam B can subsequently intercept patterning device MA, which is held on a patterning device table MT. Having traversed patterning device MA, the beam B can pass through the lens PL, which focuses beam B onto target portion C of substrate W. With the aid of the second positioning means (and interferometric measuring means IF), the substrate table WT can be moved accurately, e.g. to position different target portions C in the path of beam B. Similarly, the first positioning means can be used to accurately position patterning device MA with respect to the path of beam B, e.g., after mechanical retrieval of the patterning device MA from a patterning device library, or during a scan. In general, movement of the object tables MT, WT can be realized with the aid of a long-stroke module (coarse positioning) and a short-stroke module (fine positioning). However, in the case of a stepper (as opposed to a step-and-scan tool), patterning device table MT may be connected to a short stroke actuator, or may be fixed.

The depicted tool can be used in two different modes, step mode and scan mode. In step mode, patterning device table MT is kept essentially stationary, and an entire patterning device image is projected in one operation (i.e., a single "flash") onto a target portion C. Substrate table WT can be shifted in the x and/or y directions so that a different target portion C can be irradiated by beam B. In scan mode, essentially the same scenario applies, except that a given target portion C is not exposed in a single "flash." Instead, patterning device table MT is movable in a given direction (e.g., the "scan direction", or the "y" direction) with a speed v, so that projection beam B is caused to scan over a patterning device image. Concurrently, substrate table WT is simultaneously moved in the same or opposite direction at a speed $V = Mv$, in which M is the magnification of the lens (typically, $M = 1/4$ or $1/5$). In this manner, a relatively large target portion C can be exposed, without having to compromise on resolution.

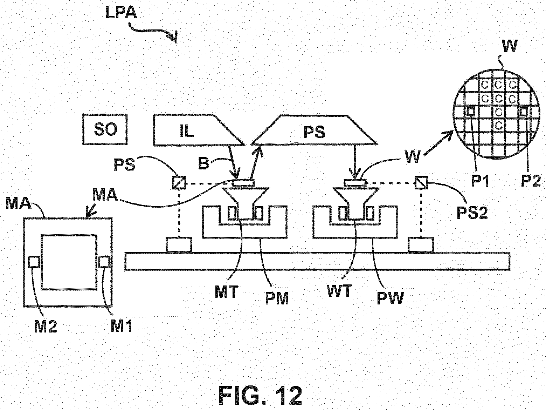

Figure 12 is a schematic diagram of another lithographic projection apparatus (LPA) that may be used for, and/or facilitating one or more of the operations described herein. LPA can include source collector module SO, illumination system (illuminator) IL configured to condition a radiation beam B (e.g. EUV radiation), support structure MT, substrate table WT, and projection system PS. Support structure (e.g. a patterning device table) MT can be constructed to support a patterning device (e.g. a mask or a reticle) MA and connected to a first positioner PM configured to accurately position the patterning device. Substrate table (e.g. a wafer table) WT can be constructed to hold a substrate (e.g. a resist coated wafer) W and connected to a second positioner PW configured to accurately position the substrate. Projection system (e.g. a reflective projection system) PS can be configured to project a pattern imparted to the radiation beam B by patterning device MA onto a target portion C (e.g. comprising one or more dies) of the substrate W.

As shown in this example, LPA can be of a reflective type (e.g. employing a reflective patterning device). It is to be noted that because most materials are absorptive within the EUV wavelength range, the patterning device may have multilayer reflectors comprising, for example, a multi-stack of molybdenum and silicon. In one example, the multi-stack reflector has a 40 layer pairs of molybdenum and silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Illuminator IL can receive an extreme ultra violet radiation beam from source collector module SO. Methods to produce EUV radiation include, but are not necessarily limited to, converting a material into a plasma state that has at least one element, e.g., xenon, lithium, or tin, with one or more emission lines in the EUV range. In one such method, often termed laser produced plasma ("LPP"), the plasma can be produced by irradiating a fuel, such as a droplet, stream or cluster of material having the line-emitting element, with a laser beam. Source collector module SO may be part of an EUV radiation system including a laser (not shown in Figure 9), for providing the laser beam exciting the fuel. The resulting plasma emits output radiation, e.g., EUV radiation, which is collected using a radiation collector, disposed in the source collector module. The laser and the source collector module may be separate entities, for example when a CO2 laser is used to provide the laser beam for fuel excitation. In this example, the laser may not be considered to form part of the lithographic apparatus and the radiation beam can be passed from the laser to the source collector module with the aid of a beam delivery system comprising, for example, suitable directing mirrors and/or a beam expander. In other examples, the source may be an integral part of the source collector module, for example when the source is a discharge produced plasma EUV generator, often termed a DPP source.

Illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B can be incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder, or capacitive sensor), the substrate table WT can be moved accurately (e.g. to position different target portions C in the path of radiation beam B). Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

The depicted apparatus LPA could be used in at least one of the following modes, step mode, scan mode, and stationary mode. In step mode, the support structure (e.g. patterning device table) MT and the substrate table WT are kept essentially stationary, while an entire pattern imparted to the radiation beam is projected onto a target portion C at one time (e.g., a single static exposure). The substrate table WT is then shifted in the X and/or Y direction so that a different target portion C can be exposed. In scan mode, the support structure (e.g. patterning device table) MT and the substrate table WT are scanned synchronously while a pattern imparted to the radiation beam is projected onto target portion C (i.e. a single dynamic exposure). The velocity and direction of substrate table WT relative to the support structure (e.g. patterning device table) MT may be determined by the (de)magnification and image reversal characteristics of the projection system PS. In stationary mode, the support structure (e.g. patterning device table) MT is kept essentially stationary holding a programmable patterning device, and substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

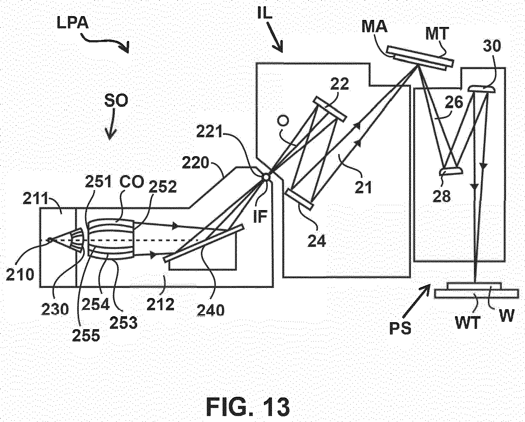

Figure 13 is a detailed view of the lithographic projection apparatus shown in Figure 12. As shown in Figure 13, the LPA can include the source collector module SO, the illumination system IL, and the projection system PS. The source collector module SO is configured such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the hot plasma 210 is created to emit radiation in the EUV range of the electromagnetic spectrum. The hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In some embodiments, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier trap 230 (described below) also includes a channel structure. The collector chamber 211 may include a radiation collector CO which may be a grazing incidence collector. Radiation collector CO has an upstream radiation collector side 251 and a downstream radiation collector side 252. Radiation that traverses collector CO can be reflected off a grating spectral filter 240 to be focused on a virtual source point IF along the optical axis indicated by the line "O". The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently, the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the radiation beam 21 at the patterning device MA, held by the support structure MT, a patterned beam 26 is formed and the patterned beam 26 is imaged by the projection system PS via reflective elements 28, 30 onto a substrate W held by the substrate table WT. More elements than shown may generally be present in illumination optics unit IL and projection system PS. The grating spectral filter 240 may optionally be present, depending upon the type of lithographic apparatus, for example. Further, there may be more mirrors present than those shown in the figures, for example there may be 1- 6 additional reflective elements present in the projection system PS than shown in Figure 13.

Collector optic CO, as illustrated in Figure 13, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

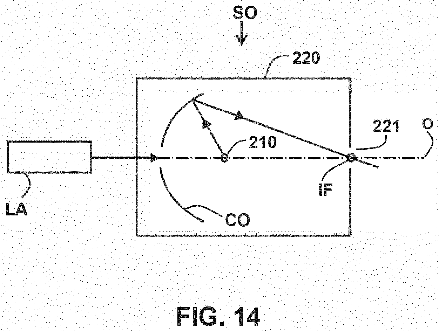

Figure 14 is a detailed view of source collector module SO of the lithographic projection apparatus LPA (shown in previous figures). Source collector module SO may be part of an LPA radiation system. A laser LA can be arranged to deposit laser energy into a fuel, such as xenon (Xe), tin (Sn) or lithium (Li), creating the highly ionized plasma 210 with electron temperatures of several 10"s of eV. The energetic radiation generated during de-excitation and recombination of these ions is emitted from the plasma, collected by a near normal incidence collector optic CO and focused onto the opening 221 in the enclosing structure 220.

The concepts disclosed herein may simulate or mathematically model any generic imaging, etching, polishing, inspection, etc. system for sub wavelength features, and may be useful with emerging imaging technologies capable of producing increasingly shorter wavelengths. Emerging technologies include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-50nm by using a synchrotron or by hitting a material (either solid or a plasma) with high energy electrons in order to produce photons within this range.

While the concepts disclosed herein may be used for manufacturing with a substrate such as a silicon wafer, it shall be understood that the disclosed concepts may be used with any type of manufacturing system (e.g., those used for manufacturing on substrates other than silicon wafers).

In addition, the combination and sub-combinations of disclosed elements may comprise separate embodiments. For example, an etching simulation model and one or more of the other models described herein may be included in separate embodiments, or they may be included together in the same embodiment.

The descriptions above are intended to be illustrative, not limiting. Thus, it will be apparent to one skilled in the art that modifications may be made as described without departing from the scope of the claims set out below.

## Claims

1. A non-transitory computer readable medium having instructions thereon to determine an etch effect to be taken into consideration during optical proximity correction and/or other patterning process optimization, the instructions when executed by a computer causing the computer to:

   receive (602) a representation of a first contour of a substrate pattern;
   determine (604) a curvature of the first contour;
   determine (606) an etch bias direction based on the curvature; and
   use (608) a simulation model to determine an etch effect based on the etch bias direction for an etching process on the substrate pattern.

2. The medium of claim 1, wherein the curvature corresponds to a curvature at a given location of the first contour, wherein the etch bias direction is for the given location and is determined based on the curvature at the given location and further based on a curvature at one or more adjacent locations along the first contour in proximity to the given location.

3. The medium of claim 2, wherein the etch bias direction for the given location on the first contour is determined based on a combination of curvatures at the one or more adjacent locations along the first contour with the curvature at the given location.

4. The medium of claim 3, wherein the combination is weighted based on the curvatures.

5. The medium of claim 1, wherein the etch bias direction for the given location on the first contour is determined based on a combination of the normal directions at the one or more adjacent locations along the first contour with the normal direction of the first contour at the given location.

6. The medium of claim 5, wherein the combination is weighted with respect to the normal directions.

7. The medium of claim 1, wherein the instructions further cause the computer to determine an etch bias value based on the representation of the first contour of the substrate pattern, and use the simulation model to determine the etch effect based on the etch bias direction and the etch bias value.

8. The medium of claim 1, wherein the etch effect is a change in the first contour of the substrate pattern caused by etching, which produces an after etch substrate pattern, and using the simulation model to determine the etch effect comprises determining one or more locations on the after etch substrate pattern based on the etch bias direction, wherein the representation of the first contour is received electronically, and the representation of the first contour is a representation of a resist contour.

9. The medium of claim 4, wherein determining the etch bias direction is performed using an algorithm comprising a combination term, a filtering term, a curvature term.

10. The medium of claim 1, wherein the simulation model is an etch bias model.

11. The medium of claim 1, wherein using the simulation model to determine the etch effect based on the etch bias direction for an etching process simulated using the substrate pattern comprises, in a calibration flow, determining the etch bias direction at each location on a gage contour of the substrate pattern.

12. The medium of claim 1, wherein using the simulation model to determine the etch effect based on the etch bias direction for an etching process simulated using the substrate pattern comprises, in a model application flow, biasing each vertex of a resist contour with a bias vector based on the etch bias direction to determine an after etch contour.

13. The medium of claim 1, wherein using the simulation model to determine the etch effect based on the etch bias direction for an etching process simulated using the substrate pattern comprises, for optical proximity correction, using a resist contour and an etch bias direction at each location on the resist contour, and determining an after etch contour, which can be used to estimate an etch signal for the optical proximity correction.

14. The medium of claim 1, wherein the etch effect is determined based on an etch bias value and the etch bias direction, and wherein the etch bias value and/or the etch bias direction are configured to be provided to a cost function to facilitate determination of costs associated with individual patterning process variables.

15. The medium of claim 1, wherein the curvature of the first contour is determined based on one or more derivatives of an equation that represents the first contour.

**Patentansprüche**

1. Ein nicht transitorisches computerlesbares Medium mit Anweisungen darauf zum Bestimmen eines Ätzeffekts, der während einer optischen Nahbereichskorrektur und/oder einer anderen Optimierung eines Musterungsprozesses berücksichtigt werden soll, wobei die Anweisungen bei Ausführung durch einen Computer den Computer zu Folgendem veranlassen:

Empfangen (602) einer Darstellung einer ersten Kontur eines Substratmusters;
Bestimmen (604) einer Krümmung der ersten Kontur;
Bestimmen (606) einer Ätzverzerrungsrichtung auf der Basis der Krümmung; und
Verwenden (608) eines Simulationsmodells zum Bestimmen eines Ätzeffekts auf der Basis der Ätzverzerrungsrichtung für einen Ätzprozess auf dem Substratmuster.

2. Medium gemäß Anspruch 1, wobei die Krümmung einer Krümmung an einer gegebenen Stelle der ersten Kontur entspricht, wobei die Ätzverzerrungsrichtung für die gegebene Stelle ist und auf der Basis der Krümmung an der gegebenen Stelle und ferner auf der Basis einer Krümmung an einer oder mehreren benachbarten Stellen entlang der ersten Kontur in der Nähe der gegebenen Stelle bestimmt wird.

3. Medium gemäß Anspruch 2, wobei die Ätzverzerrungsrichtung für die gegebene Stelle auf der ersten Kontur auf der Basis einer Kombination von Krümmungen an der einen oder den mehreren benachbarten Stellen entlang der ersten Kontur mit der Krümmung an der gegebenen Stelle bestimmt wird.

4. Medium gemäß Anspruch 3, wobei die Kombination auf der Basis der Krümmungen gewichtet ist.

5. Medium gemäß Anspruch 1, wobei die Ätzverzerrungsrichtung für die gegebene Stelle auf der ersten Kontur auf der Basis einer Kombination der senkrechten Richtungen an der einen oder den mehreren benachbarten Stellen entlang der ersten Kontur mit der senkrechten Richtung der ersten Kontur an der gegebenen Stelle bestimmt wird.

6. Medium gemäß Anspruch 5, wobei die Kombination in Bezug auf die senkrechten Richtungen gewichtet ist.

7. Medium gemäß Anspruch 1, wobei die Anweisungen den Computer ferner dazu veranlassen, einen Ätzverzerrungswert auf der Basis der Darstellung der ersten Kontur des Substratmusters zu bestimmen und das Simulationsmodell zu verwenden, um den Ätzeffekt auf der Basis der Ätzverzerrungsrichtung und des Ätzverzerrungswerts zu bestimmen.

8. Medium gemäß Anspruch 1, wobei der Ätzeffekt eine durch Ätzen bewirkte Änderung der ersten Kontur des Substratmusters ist, die ein Nachätzungssubstratmuster produziert, und das Verwenden des Simulationsmodells zum Bestimmen des Ätzeffekts das Bestimmen einer oder mehrerer Stellen auf dem Nachätzungssubstratmuster auf der Basis der Ätzverzerrungsrichtung beinhaltet, wobei die Darstellung der ersten Kontur elektronisch empfangen wird und die Darstellung der ersten Kontur eine Darstellung einer Resistkontur ist.

9. Medium gemäß Anspruch 4, wobei das Bestimmen der Ätzverzerrungsrichtung unter Verwendung eines Algorithmus durchgeführt wird, der einen Kombinationsterm, einen Filterterm, einen Krümmungsterm und einen Kalibrierungsterm beinhaltet.

10. Medium gemäß Anspruch 1, wobei das Simulationsmodell ein Ätzverzerrungsmodell ist.

11. Medium gemäß Anspruch 1, wobei das Verwenden des Simulationsmodells zum Bestimmen des Ätzeffekts auf der Basis der Ätzverzerrungsrichtung für einen unter Verwendung des Substratmusters simulierten Ätzprozess in einem Kalibrierungsablauf das Bestimmen der Ätzverzerrungsrichtung an jeder Stelle auf einer Messkontur des Substratmusters beinhaltet.

12. Medium gemäß Anspruch 1, wobei das Verwenden des Simulationsmodells zum Bestimmen des Ätzeffekts auf der Basis der Ätzverzerrungsrichtung für einen unter Verwendung des Substratmusters simulierten Ätzprozess in einem Modellanwendungsablauf das Verzerren jedes Scheitelpunkts einer Resistkontur mit einem Verzerrungsvektor auf der Basis der Ätzverzerrungsrichtung zum Bestimmen einer Nachätzungskontur beinhaltet.

13. Medium gemäß Anspruch 1, wobei das Verwenden des Simulationsmodells zum Bestimmen des Ätzeffekts auf der Basis der Ätzverzerrungsrichtung für einen unter Verwendung des Substratmusters simulierten Ätzprozess das Verwenden, für eine optische Nahbereichskorrektur, einer Resistkontur und einer Ätzverzerrungsrichtung an jeder Stelle auf der Resistkontur und das Bestimmen einer Nachätzungskontur, die verwendet werden kann, um ein Ätzsignal für die optische Nahbereichskorrektur zu schätzen, beinhaltet.

14. Medium gemäß Anspruch 1, wobei der Ätzeffekt auf der Basis eines Ätzverzerrungswerts und der Ätzverzerrungsrichtung bestimmt wird und wobei der Ätzverzerrungswert und/oder die Ätzverzerrungsrichtung konfiguriert sind, um einer Kostenfunktion bereitgestellt zu werden, um die Bestimmung von mit individuellen Variablen des Musteraufbringungsprozesses assoziierten Kosten zu erleichtern.

15. Medium gemäß Anspruch 1, wobei die Krümmung der ersten Kontur auf der Basis einer oder mehrerer Ableitungen einer Gleichung, die die erste Kontur darstellt, bestimmt wird.

**Revendications**

1. Un support lisible par ordinateur non transitoire sur lequel se trouvent des instructions pour déterminer un effet de gravure à prendre en considération durant une correction de proximité optique et/ou une optimisation d'autres processus servant à donner un motif, les instructions, lorsqu'exécutées par un ordinateur, amenant l'ordinateur :

   à recevoir (602) une représentation d'un premier contour d'un motif de substrat ;
   à déterminer (604) une courbure du premier contour ;
   à déterminer (606) une direction de biais de gravure sur la base de la courbure ; et
   à utiliser (608) un modèle de simulation pour déterminer un effet de gravure sur la base de la direction de biais de gravure pour un processus de gravure sur le motif de substrat.

2. Le support de la revendication 1, dans lequel la courbure correspond à une courbure à un emplacement donné du premier contour, la direction de biais de gravure étant pour l'emplacement donné et étant déterminée sur la base de la courbure à l'emplacement donné et sur la base en sus d'une courbure à un ou plusieurs emplacements adjacents le long du premier contour à proximité de l'emplacement donné.

3. Le support de la revendication 2, dans lequel la direction de biais de gravure pour l'emplacement donné sur le premier contour est déterminée sur la base d'une combinaison de courbures aux un ou plusieurs emplacements adjacents le long du premier contour avec la courbure à l'emplacement donné.

4. Le support de la revendication 3, dans lequel la combinaison est pondérée sur la base des courbures.

5. Le support de la revendication 1, dans lequel la direction de biais de gravure pour l'emplacement donné sur le premier contour est déterminée sur la base d'une combinaison des directions normales aux un ou plusieurs emplacements adjacents le long du premier contour avec la direction normale du premier contour à l'emplacement donné.

6. Le support de la revendication 5, dans lequel la combinaison est pondérée par rapport aux directions normales.

**7.** Le support de la revendication 1, dans lequel les instructions amènent en sus l'ordinateur à déterminer une valeur de biais de gravure sur la base de la représentation du premier contour du motif de substrat, et à utiliser le modèle de simulation pour déterminer l'effet de gravure sur la base de la direction de biais de gravure et de la valeur de biais de gravure.

**8.** Le support de la revendication 1, dans lequel l'effet de gravure est un changement dans le premier contour du motif de substrat causé par la gravure, produisant un motif de substrat post-gravure, et le fait d'utiliser le modèle de simulation pour déterminer l'effet de gravure comprend le fait de déterminer un ou plusieurs emplacements sur le motif de substrat post-gravure sur la base de la direction de biais de gravure, dans lequel la représentation du premier contour est reçue électroniquement, et la représentation du premier contour est une représentation d'un contour de réserve.

**9.** Le support de la revendication 4, dans lequel le fait de déterminer la direction de biais de gravure est réalisé en utilisant un algorithme comprenant un terme de combinaison, un terme de filtrage, un terme de courbure, et un terme de calibration.

**10.** Le support de la revendication 1, dans lequel le modèle de simulation est un modèle de biais de gravure.

**11.** Le support de la revendication 1, dans lequel le fait d'utiliser le modèle de simulation pour déterminer l'effet de gravure sur la base de la direction de biais de gravure pour un processus de gravure simulé en utilisant le motif de substrat comprend, dans un flux de calibration, le fait de déterminer la direction de biais de gravure à chaque emplacement sur un contour de gabarit du motif de substrat.

**12.** Le support de la revendication 1, dans lequel le fait d'utiliser le modèle de simulation pour déterminer l'effet de gravure sur la base de la direction de biais de gravure pour un processus de gravure simulé en utilisant le motif de substrat comprend, dans un flux d'application de modèle, le fait de biaiser chaque sommet d'un contour de réserve avec un vecteur de biais basé sur la direction de biais de gravure pour déterminer un contour post-gravure.

**13.** Le support de la revendication 1, dans lequel le fait d'utiliser le modèle de simulation pour déterminer l'effet de gravure sur la base de la direction de biais de gravure pour un processus de gravure simulé en utilisant le motif de substrat comprend, pour une correction de proximité optique, le fait d'utiliser un contour de réserve et une direction de biais de gravure à chaque emplacement sur le contour de réserve, et le fait de déterminer un contour post-gravure, pouvant être utilisé pour estimer un signal de gravure pour la correction de proximité optique.

**14.** Le support de la revendication 1, dans lequel l'effet de gravure est déterminé sur la base d'une valeur de biais de gravure et de la direction de biais de gravure, et dans lequel la valeur de biais de gravure et/ou la direction de biais de gravure sont configurées pour être fournies à une fonction de coût afin de faciliter la détermination de coûts associés à des variables individuelles de processus servant à donner un motif.

**15.** Le support de la revendication 1, dans lequel la courbure du premier contour est déterminée sur la base d'une ou de plusieurs dérivées d'une équation qui représente le premier contour.

**FIG. 1**

FIG. 2

FIG. 3

**FIG. 4**

EP 4 433 869 B1

502

500

504

FIG. 5

600

602

604

606

608

610

FIG. 6

**FIG. 7**

**FIG. 8**

FIG. 9

FIG. 10

FIG. 11

FIG. 12

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6046792 A
- US 5229872 A
- US 20080301620 A
- US 20070050749 A
- US 20070031745 A
- US 20080309897 A
- US 20100162197 A
- US 20100180251 A
- US 7587704 B
- US 8200468 B

**Non-patent literature cited in the description**

- **WEISBUCH FRANÇOIS**. Introducing etch kernels for efficient pattern sampling and etch bias prediction. *Journal of Micro/Nanolithography, MEMS, and MOEMS*, 06 March 2018, vol. 17 (01), ISSN 1932-5150, 1